Europäisches Patentamt

European Patent Office

Office européen des brevets

(19)

(11) Publication number: **0 228 761 B1**

(12) **EUROPEAN PATENT SPECIFICATION**

(45) Date of publication of patent specification: **22.07.92**

(51) Int. Cl.⁵: **H01L 29/78**, H01L 29/60, //G11C17/00

(21) Application number: **86307291.4**

(22) Date of filing: **23.09.86**

(54) Semiconductor non-volatile memory.

(30) Priority: **15.10.85 JP 229403/85**

(43) Date of publication of application:
**15.07.87 Bulletin 87/29**

(45) Publication of the grant of the patent:
**22.07.92 Bulletin 92/30**

(84) Designated Contracting States:
**DE GB**

(56) References cited:
**EP-A- 0 035 160**
**EP-A- 0 052 982**
**EP-A- 0 062 460**
**US-A- 4 099 196**

(73) Proprietor: **SEIKO INSTRUMENTS INC.**
**31-1, Kameido 6-chome Koto-ku**
**Tokyo 136(JP)**

(72) Inventor: **Hirai, Yoshio c/o Seiko Instr. & Electronics Ltd.**
**31-1, Kameido 6-chome**
**Koto-ku Tokyo 136(JP)**

(74) Representative: **Miller, Joseph et al**
**J. MILLER & CO. 34 Bedford Row, Holborn**
**London WC1R 4JH(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

This invention relates to semiconductor non-volatile memories, for example, for use in computers and office automation machines, etc.

The present invention seeks to provide a semiconductor non-volatile memory for use in computers etc., wherein an erasing electrode and a writing electrode are provided around a floating gate electrode through respective tunnel insulator films, thereby improving the reliability of the semiconductor non-volatile memory.

Semiconductor non-volatile memories are widely used in computers etc. since they are smaller in size than other types of memory and enable high-speed reading. Figure 2 is a sectional view of a general electrically erasable and programmable non-volatile memory (hereinafter referred to as an "EEPROM"). On the surface of a P-type semiconductor substrate 11, N$^+$-type source and drain regions 13 are formed, and a floating gate electrode 15 is provided thereon through a gate insulator film 14. A control gate electrode 16 is provided for controlling the potential of the floating gate electrode 15 through an insulator film 102. The transfer of electric charge in relation to the floating gate electrode 15 is effected through a tunnel oxide film 17 provided on the drain region 13. For example, in the case where the thickness of the tunnel oxide film 17 is about 200Å (1nm = 10Å), when a voltage which is 20V higher than the potential of the drain region 13 is applied to the control gate electrode 16, a strong electric field is applied to the tunnel oxide film 17, causing electrons to flow from the drain region 13 into the floating gate electrode 15. To make electrons flow out of the floating electrode 15 into the drain region 13 in the reverse direction, it suffices to apply a voltage to the drain region 13 which voltage is 20V higher than the potential of the control gate electrode 16. Since the channel conductance between the source and drain regions under the floating gate electrode 15, which serves as a gate electrode, changes in accordance with the amount of electric charge accummulated in the floating gate electrode 15, it is possible to read out data.

An example of this kind of semiconductor non-volatile memory is disclosed in US-A-4,203,158. Non-volatile memories with separated erasing and writing electrodes are known from EP-A-0 035 160 and US-A-4 099 196. In EP-A-0 052 982 erasing electrode arrangement as used in the present invention is disclosed.

In the case of an EEPROM such as shown in Figure 2 in which a strong electric field is applied to a tunnel oxide film to write data, the strong electric field leads to wear and deterioration of the tunnel oxide film, so that repetitive rewriting results in breakdown of the EEPROM.

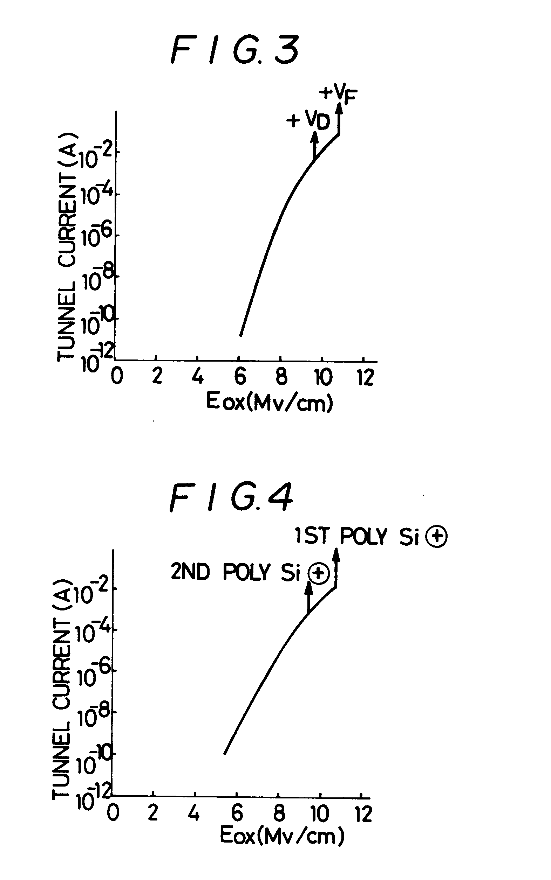

The deterioration of a tunnel oxide film due to wear has been examined carefully, and it has been found that wear is dependent upon direction of the applied electric field. The results of the examination are given in Figure 3 which shows tunnel current with respect to the electric field $E_{ox}$ applied to a tunnel oxide film. Breakdown takes place at a smaller current value when electrons are made to flow out of a floating gate electrode (when +20V is applied to the drain region; +$V_D$). In other words, it may be considered that breakdown occurs in an EEPROM such as that shown in Figure 2 when it is in an erasing mode (when electrons are made to flow out of the floating gate electrode).

On the basis of this fact, the occurrence of breakdown of a semi conductor non-volatile memory according to the present invention due to rewriting is reduced or prevented by providing erasing and writing electrodes separately from each other. By providing the erasing and writing electrodes separately from each other, the direction in which electrons flow through each of two tunnel insulator films is limited to only one direction.

According to one aspect of the present invention there is provided a semiconductor non-volatile memory comprising: a semi-conductor substrate of a first conductivity type; source and drain regions of a second conductivity type formed in the surface of said semiconductor substrate in such a manner as to be spaced apart from each other; a floating gate electrode formed on the surface of a portion of said semiconductor substrate between said source and drain regions through a gate insulator film; an erasing electrode provided in opposing relation to said floating gate electrode through a first tunnel insulator film; and a writing electrode provided in opposing relation to said floating gate electrode through a second tunnel insulator film, characterised in that the portion of the floating gate electrode opposing the erasing electrode through the first tunnel film is provided above the erasing electrode

The positional relationship between said erasing electrode, said writing electrode and said floating gate electrode may be arranged in order to maximise the breakdown current value of each of said first and second tunnel insulator films.

In one embodiment the writing electrode is provided above the floating gate electrode through the second tunnel insulator film.

According to another aspect of the present invention there is provided a semi-conducdtor non-volatile memory comprising:

a semiconductor substrate of a first conductivity type; a writing electrode of a second conductivity type formed in the surface of said semiconductor substrate; and a floating gate electrode formed on the surface of a portion of said semiconductor substrate which is located between source and drain regions through a gate insulator film, and provided in opposing relation to said drain region through a first tunnel insulator film, characterised by an erasing electrode provided in opposing relation to said floating gate electrode through a second tunnel insulator film.

The invention is illustrated, merely by way of example, in the accompanying drawings, in which:-

Figure 1 is a sectional view of one embodiment of a semi-conductor non-volatile memory according to the present invention;

Figure 2 is a sectional view of a conventional semiconductor non-volatile memory;

Figure 3 is a chart showing electric characteristics of a tunnel oxide film on $N^+$-type single crystal silicon;

Figure 4 is a chart showing electric characteristics of a tunnel oxide film on polysilicon employed in a semiconductor non-volatile memory according to the present invention; and

Figure 5 is a sectional view of a second embodiment of a semiconductor non-volatile memory according to the present invention.

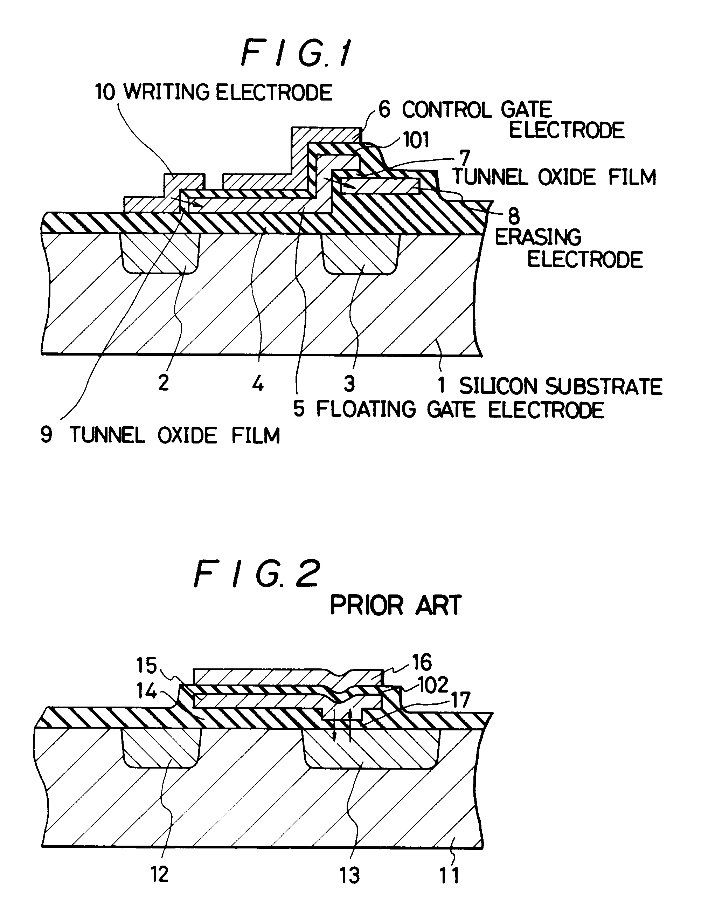

Referring first to Figure 1, a semiconductor non-volatile memory according to the present invention has, on the surface of a P-type semiconductor substrate 1,$N^+$-type source and drain regions 2,3. A floating gate electrode 5 is provided through a gate insulator film 4 on a channel region between the source and drain regions. In addition, a control gate electrode 156 is provided above the floating gate electrode 5 through an insulator film 101. An erasing electrode 8 for causing electrons to flow out of the floating gate electrode 5 is provided below the floating gate electrode through a tunnel oxide film 7. A writing electrode 10 is provided above the floating gate electrode 5 through a tunnel oxide film 9.

To effect writing (i.e. to inject electrons into the floating gate electrode 5), a writing voltage is applied to the control gate electrode 6 and the erasing electrode 8 with respect to the writing electrode 10. To effect erasing, an erasing voltage is applied to the erasing electrode 8 with respect to the writing electrode 10 and the control gate electrode 6. Rewriting is effected by moving electrons from a polysilicon third-level layer which constitutes the writing electrode 10 to a polysilicon second-level layer which constitutes the floating gate electrode 5 and from the electrode 5 to the erasing electrode 8 which constitutes a polysilicon first-level layer.

Figure 4 is a timing chart showing the characteristics of the tunnel oxidefilms employed in a semiconductor non-volatile memory according to the present invention. Figure 4 shows tunnel current with respect to the applied electric field.

It is more difficult for the tunnel oxide film to break down in the case where a positive voltage is applied to the polysilicon first-level layer than in the case of the polysilicon second-level layer. Accordingly, the structure shown in Figure 1 enables realisation of an EEPROM in which the occurrence of breakdown due to rewriting is suppressed.

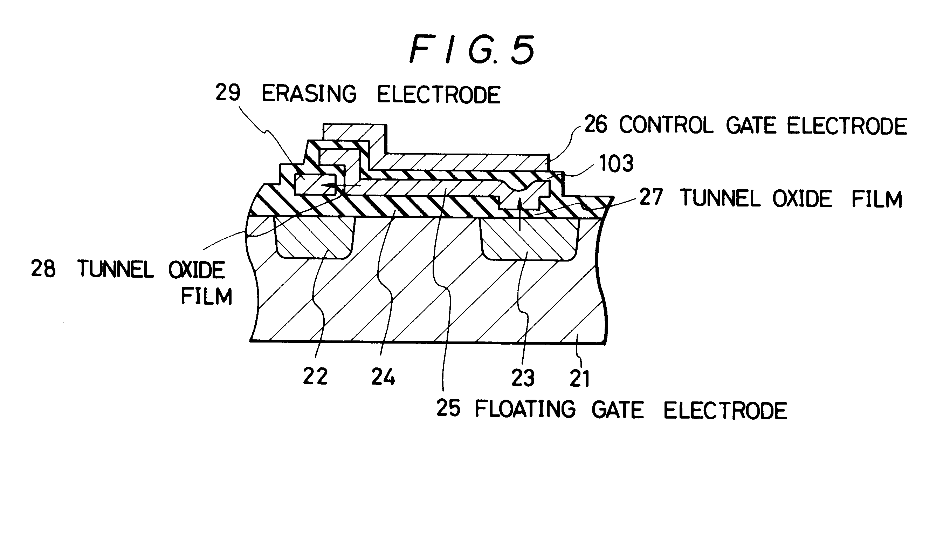

Figure 5 shows a second embodiment of the semiconductor non-volatile memory according to the present invention. The semiconductor non-volatile memory has a P-type silicon substrate 1, $N^+$-type source and drain regions 22,23, a gate insulator film 24, a control gate electrode 26 and an insulating film 103. Rewriting is effected by moving electrons from the drain region 23 to a floating gate electrode 25 and from the floating gate electrode 25 to an erasing electrode 29. Thus, the second embodiment has a structure in which rewriting is carried out by applying a strong electric field to each tunnel oxide film 27,28 only in the direction in which it is difficult for the tunnel oxide film to break down.

The semiconductor non-volatile memories according to the present invention and described above have a structure in which two tunnel oxide films are provided so that rewriting is effected by applying a strong electric field to each of the tunnel oxide films in only one direction in which it is difficult for the tunnel oxide film to become worn due to the application of the electric field. It is therefore possible to realise semiconductor non-volatile memories which can endure many more rewriting operations than conventional semiconductor non-volatile memories.

## Claims

1. A semiconductor non-volatile memory comprising: a semi-conductor substrate (1;21) of a first conductivity type; source and drain regions (2,3; 22,23) of a second conductivity type formed in the surface of said semiconductor substrate in such a manner as to be spaced apart from each other; a floating gate electrode (5;25) formed on the surface of a portion of said semiconductor substrate between said source and drain regions through a gate insulator film (4;24); an erasing electrode (8;29) provided in opposing relation to said floating gate electrode through a first tunnel insulator film (7;28) and a writing electrode (10;23) provided in opposing relation to said floating gate electrode through a second tunnel insulator film (9;27) characterised in that the portion of the floating gate electrode (5;25) opposing the erasing electrode (8;29) through the first tunnel insulator film (7;28) is provided above the erasing electrode (8;29).

**2.** A semiconductor non-volatile memory as claimed in claim 1, characterised in that the portion of the floating gate electrode (5;25) opposing the writing electrode (10;23) through the second tunnel insulator film (9;27) is provided below the writing electrode (10;23).

**3.** A semiconductor non-volatile memory as claimed in claim 1 characterised in that the writing electrode (10,23) is formed in a surface portion of the semiconductor substrate (21) under the floating gate electrode (25).

**4.** A method of using a semiconductor non-volatile memory as claimed in any preceding claim characterised in that the breakdown current through the first and second tunnel insulator films (7,9; 28,27) is maximized.

**Revendications**

**1.** Une mémoire non volatile à semiconducteurs comprenant : un substrat semiconducteur (1; 21) d'un premier type de conductivité; des régions de source et de drain (2, 3; 22, 23) d'un second type de conductivité, formées dans la surface du substrat semiconducteur de manière à être mutuellement espacées; une électrode de grille flottante (5; 25) formée sur la surface d'une partie du substrat semiconducteur, entre les régions de source et de drain, avec interposition d'une couche d'isolation de grille (4; 24); une électrode d'effacement (8; 29) formée face a l'électrode de grille flottante, avec interposition d'une première couche d'isolation à effet tunnel (7; 28) et une électrode d'écriture (10; 23) formée face à l'électrode de grille flottante avec interposition d'une seconde couche d'isolation à effet tunnel (9; 27), caractérisée en ce que la partie de l'électrode de grille flottante (5; 25) qui se trouve face à l'électrode d'effacement (8; 29) avec interposition de la première couche d'isolation à effet tunnel (7; 28) est formée au-dessus de l'électrode d'effacement (8; 29).

**2.** Une mémoire non volatile à semiconducteurs selon la revendication 1, caractérisée en ce que la partie de l'électrode de grille flottante (5) qui se trouve face à l'électrode d'écriture (10) avec interposition de la seconde couche d'isolation à effet tunnel (9) est formée au-dessous de l'électrode d'écriture (10).

**3.** Une mémoire non volatile à semiconducteurs selon la revendication 1, caractérisée en ce que l'électrode d'écriture (23) est formée dans une partie de surface du substrat semiconducteur (21) se trouvant sous l'électrode de grille flottante (25).

**4.** Un procédé d'utilisation d'une mémoire non volatile le à semiconducteurs selon l'une quelconque des revendications précédentes, caractérisé en ce que le courant de claquage à travers les première et seconde couches d'isolation à effet tunnel (7, 9; 28, 27) est maximisé.

**Patentansprüche**

**1.** Nichtflüchtiger Halbleiterspeicher mit einem Halbleitersubstrat (1; 21) eines ersten Leitungstyps, einer Source- und Drain-Zone (2, 3; 22, 23) eines Zweiten Leitungstyps, die an einer Seite im Halbleitersubstrat beabstandet voneinander vorgesehen sind, einer über einer Gate-Isolatorschicht (4; 24) auf einem Teil der Seite des Halbleitersubstrats zwischen der Source- und Drain-Zone vorgesehenen Floating-Gate-Elektrode (5; 25), einer der Floating-Gate-Elektrode über einer ersten Tunnelisolatorschicht (7; 28) gegenüberstehend vorgesehenen Löschelektrode (8; 29) und einer der Floating-Gate-Elektrode über einer zweiten Tunnelisolatorschicht (9; 27) gegenüberstehend vorgesehenen Schreibelektrode (9; 27), **dadurch gekennzeichnet,** daß, der der Löschelektrode (8; 29) über die erste Tunnelisolatorschicht (7; 28) gegenüberstehende Teil der Floating-Gate-Elektrode (5; 25) oberhalb der Löschelektrode (8; 29) vorgesehen ist.

**2.** Nichtflüchtiger Halbleiterspeicher nach Anspruch 1, **dadurch gekennzeichnet,** daß der der Schreibelektrode (10) über die zweite Tunnelisolatorschicht (9) gegenüberstehende Teil der Floating-Gate-Elektrode (5) unterhalb der Schreibelektrode (10) vorgesehen ist.

**3.** Nichtflüchtiger Halbleiterspeicher nach Anspruch 1, **dadurch gekennzeichnet,** daß die Schreibelektrode (23) in einem Teil des Halbleitersubstrats (21) an einer Seite unterhalb der Floating-Gate-Elektrode (25) vorgesehen ist.

**4.** Verfahren zur Anwendung eines nichtflüchtigen Halbleiterspeichers nach den vorhergehenden Ansprüchen, **dadurch gekennzeichnet,** daß der Durchbruchstrom durch die erste und zweite Tunnelisolatorschicht (7, 9; 28, 27) maximiert wird.

# F I G. 1

10 WRITING ELECTRODE
6 CONTROL GATE ELECTRODE
101
7 TUNNEL OXIDE FILM
8 ERASING ELECTRODE
2   4   3   1 SILICON SUBSTRATE
5 FLOATING GATE ELECTRODE
9 TUNNEL OXIDE FILM

# F I G. 2

PRIOR ART

15
14
16
102 17
12   13   11

# F I G. 3

# F I G. 4

# FIG. 5

29 ERASING ELECTRODE

26 CONTROL GATE ELECTRODE

103

27 TUNNEL OXIDE FILM

28 TUNNEL OXIDE FILM

22    24    23    21

25 FLOATING GATE ELECTRODE

EP 0 228 761 B1